# EUROPEAN PATENT APPLICATION

(11) **EP 4 199 669 A1**
(43) Date of publication of application: **21.06.2023**
(21) Application number: 21859932.2
(22) Date of filing: 13.07.2021
(51) Int. Cl.: H05K 7/20

(54) **HEAT DISSIPATION ASSEMBLY AND AUTOMOBILE**

(30) Priority: 31.08.2020 CN 202010901484
(71) Applicant: Huawei Technologies Co., Ltd., Shenzhen, Guangdong 518129 (CN)
(72) Inventor: PENG, Yaofeng, Shenzhen, Guangdong 518129 (CN)
(74) Representative: Gill Jennings & Every LLP
(86) International application number: PCT/CN2021/105891
(87) International publication number: WO 2022/042092

(57) **Abstract**

Embodiments of this application provide a heat dissipation assembly, including a liquid cold plate, a temperature equalization plate, and a thermally conductive assembly. One side of the temperature equalization plate is attached to a heat emitting device on a main board. The liquid cold plate is disposed on a side that is of the temperature equalization plate and that is away from the main board. APCB board is fastened between the temperature equalization plate and the liquid cold plate, a connector is fastened on the PCB board, one end of the connector is connected to the PCB board, the connector passes through the temperature equalization plate, and the other end of the connector extends to the main board and is fastened on the main board. The liquid cold plate is connected to the temperature equalization plate by using the thermally conductive assembly, so that heat generated by the heat emitting device is transferred to the liquid cold plate by using the temperature equalization plate and the thermally conductive assembly. The heat dissipation assembly provided in this application may be applied to an autonomous vehicle, an intelligent vehicle, a networked vehicle, or a new energy vehicle. In this embodiment, the temperature equalization plate transfers the heat of the heat emitting device on the main board to the liquid cold plate, and the PCB board is disposed between the temperature equalization plate and the liquid cold plate, so that the connector between the PCB board and the main board does not interrupt a runner of the liquid cold plate, thereby improving heat dissipation performance of the liquid cold plate.

## Description

This application claims priority to Chinese Patent Application No. 202010901484.2, filed with the China National Intellectual Property Administration on August 31, 2020 and entitled "HEAT DISSIPATION ASSEMBLY AND VEHICLE", which is incorporated herein by reference in its entirety.

### TECHNICAL FIELD

This application relates to the field of hardware structure technologies, and in particular, to a heat dissipation assembly and a vehicle.

### BACKGROUND

Currently, there is a new architecture of an automated driving module. A printed circuit board (printed circuit board, PCB) arranged with an artificial intelligence (artificial intelligence, AI) chip (which may also be referred to as an AI daughter board) is mounted on a main board by using a connector. One AI daughter board has a specific computing power. A quantity of mounted AI boards is determined based on a computing power required by a customer, and data reasoning or data analysis may be flexibly configured.

In an existing implementation, a liquid cold plate may be placed between the main board and the daughter board to dissipate heat from a heat emitting device on the main board. Main heat emitting devices on the main board and the daughter board are attached to the liquid cold plate for heat dissipation. Heat from the heat emitting devices may be dissipated by using the liquid cold plate, thereby resolving a problem that it is difficult to dissipate heat from a device between the daughter board and the main board. However, the liquid cold plate has a limited thickness and a poor heat dissipation capability due to a small space between the daughter board and the main board. Consequently, it is difficult to support heat dissipation of a main chip with large power consumption. In addition, a capacitor and an inductor that are between a daughter board connector and both of the main board and the daughter board need to pass through the liquid cold plate. In this case, a runner in the liquid cold plate is interrupted. Consequently, the heat dissipation capability of the liquid cold plate is degraded.

### SUMMARY

According to a first aspect, this application provides a heat dissipation assembly, including a liquid cold plate, a temperature equalization plate, and a thermally conductive assembly, where one side of the temperature equalization plate is attached to a heat emitting device on a main board; the liquid cold plate is disposed on a side that is of the temperature equalization plate and that is away from the main board; a PCB board is fastened between the temperature equalization plate and the liquid cold plate, a connector is fastened on the PCB board, one end of the connector is connected to the PCB board, the connector passes through the temperature equalization plate, and the other end of the connector extends to the main board and is fastened on the main board; and the liquid cold plate is connected to the temperature equalization plate by using the thermally conductive assembly, so that heat generated by the heat emitting device is transferred to the liquid cold plate by using the temperature equalization plate and the thermally conductive assembly. The temperature equalization plate may be a thin copper plate with good thermal conductivity, a thin aluminum plate welded with a heat pipe, a thin flat heat pipe, a graphene sheet, or the like. This is not limited in this application. The heat emitting device may be a device, for example, an SOC (System on Chip), a local area network switch LAN SW, or a microcontroller unit. The liquid cold plate may be of a structure that has thermal conduction and heat dissipation functions. In an optional implementation, the liquid cold plate is a metal plate. For example, the liquid cold plate is an aluminum alloy material or a steel plate. In another implementation, the liquid cold plate may alternatively be another thermally conductive material, for example, a ceramic plate or plastic having a thermal conduction capability. In another implementation, the liquid cold plate may include a pipeline, and the pipeline may be filled with liquid, so that heat is removed through liquid flowing. The liquid may be water or another refrigerant.

In this embodiment of this application, the PCB board arranged with an AI chip may be fastened on the main board. In an existing implementation, the liquid cold plate is disposed between the PCB board arranged with the AI chip and the main board to dissipate heat from the PCB board arranged with the AI chip and the heat emitting device on the main board. However, in an aspect, the PCB board arranged with the AI chip is connected to the main board by using the connector, the connector affects a structure of the liquid cold plate, and a distance between the PCB board arranged with the AI chip and the main board is excessively small. Consequently, a thickness of the liquid cold plate is limited, and heat dissipation efficiency is low. In this embodiment of this application, the liquid cold plate is disposed on a side that is of the PCB board and that is away from the main board, and the connector passes through only the temperature equalization plate between the main board and the PCB board without passing through the liquid cold plate. Because the temperature equalization plate conducts heat by using metal and does not have a runner inside, a problem that a heat dissipation capability is significantly degraded because a runner is interrupted does not exists, thereby improving heat dissipation performance of the liquid cold plate.

In a possible implementation, one end of the thermally conductive assembly is fastened to the liquid cold plate, and the other end of the thermally conductive assembly extends to the temperature equalization plate and is connected to the temperature equalization plate.

In a possible implementation, a central area of the temperature equalization plate is attached to the heat emitting device on the main board, and an edge area of the temperature equalization plate extends to the main board and is fastened on the main board. This is equivalent to that the temperature equalization plate is of a "cover-shaped" structure. The central area of the temperature equalization plate protrudes in a direction away from the main board to form a hollowed area. An inner wall of the hollowed area may be attached to the heat emitting device, and the edge area of the temperature equalization plate is fastened to the main board, so that heat on the main board can be transferred to the temperature equalization plate. It should be understood that the "central area" and the "edge area" are relative position expressions, and are not absolute position limitations. In other words, the central area of the temperature equalization plate is closer to a center of the temperature equalization plate relative to the edge area. In another implementation, a non-edge area of the temperature equalization plate may alternatively be fastened to the main board, provided that it can be ensured that the temperature equalization plate is fastened to the main board, and an area for the heat emitting device can be reserved between the temperature equalization plate and the main board. A fastening manner between the temperature equalization plate and the main board is not limited in this application.

In a possible implementation, an SOC is arranged on the PCB board.

In a possible implementation, the SOC is arranged on a side that is of the PCB board and that faces the liquid cold plate, and the SOC is attached to the liquid cold plate. In this case, heat generated by the SOC on the PCB board or another heat emitting device can be directly transferred to the liquid cold plate.

In a possible implementation, the SOC is arranged on a side that is of the PCB board and that faces the temperature equalization plate, and the SOC is attached to the temperature equalization plate. In this case, heat generated by the SOC on the PCB board or another heat emitting device can be transferred to the temperature equalization plate, and be further transferred to the liquid cold plate by using the temperature equalization plate and the thermally conductive assembly.

According to a second aspect, this application provides a vehicle-mounted computing apparatus mounting method, including:
attaching one side of a temperature equalization plate to a heat emitting device on a main board;
fastening a PCB board between the temperature equalization plate and a liquid cold plate, where a connector is fastened on the PCB board, and one end of the connector is connected to the PCB board;
passing the connector through the temperature equalization plate, so that the other end of the connector extends to the main board and is fastened on the main board; and
connecting the liquid cold plate to the temperature equalization plate by using a thermally conductive assembly.

According to a third aspect, this application provides a vehicle, including a vehicle body and the heat dissipation assembly that is in any implementation of the first aspect and that is disposed in the vehicle body.

Based on the designs provided in the foregoing aspects, this application may be further combined to provide more designs.

An embodiment of this application provides a heat dissipation assembly, including a liquid cold plate, a temperature equalization plate, and a thermally conductive assembly, where one side of the temperature equalization plate is attached to a heat emitting device on a main board; the liquid cold plate is disposed on a side that is of the temperature equalization plate and that is away from the main board; and the liquid cold plate is connected to the temperature equalization plate by using the thermally conductive assembly, so that heat generated by the heat emitting device is transferred to the liquid cold plate by using the temperature equalization plate and the thermally conductive assembly. In the foregoing manner, the temperature equalization plate is added to the main board, and the liquid cold plate is disposed on the side that is of the temperature equalization plate and that is away from the main board. The temperature equalization plate transfers the heat of the heat emitting device on the main board to the liquid cold plate. A PCB board may be disposed between the temperature equalization plate and the liquid cold plate, so that a runner in the liquid cold plate is not interrupted by a connector between the PCB board and the main board, thereby improving heat dissipation performance of the liquid cold plate.

### BRIEF DESCRIPTION OF DRAWINGS

FIG. 1a is a schematic diagram of a structure of a vehicle according to an embodiment of this application;
FIG. 1b shows a schematic structure of a heat dissipation assembly according to an embodiment of this application;
FIG. 2 shows a schematic structure of a heat dissipation assembly according to an embodiment of this application;
FIG. 3 shows a schematic structure of a heat dissipation assembly according to an embodiment of this application; and
FIG. 4 shows a schematic structure of a heat dissipation assembly according to an embodiment of this application.

### DESCRIPTION OF EMBODIMENTS

The following describes embodiments of this application with reference to the accompanying drawings in embodiments of this application. Terms used in implementation parts of this application are merely used to describe specific embodiments of this application, and are not intended to limit this application.

The following describes embodiments of this application with reference to the accompanying drawings. Aperson of ordinary skill in the art may know that, with development of a technology and emergence of a new scenario, technical solutions provided in embodiments of this application are also applicable to similar technical problems.

In the specification, claims, and accompanying drawings of this application, the terms "first", "second", and so on are intended to distinguish between similar objects but do not necessarily indicate a specific order or sequence. It should be understood that the terms used in such a way are interchangeable in proper circumstances, and this is merely a discrimination manner for describing objects having a same attribute in embodiments of this application. In addition, the terms "include", "contain" and any other variants mean to cover the non-exclusive inclusion, so that a process, method, system, product, or device that includes a series of units is not necessarily limited to those units, but may include other units not expressly listed or inherent to such a process, method, system, product, or device.

First, an application scenario of a heat dissipation assembly provided in this application is described. The heat dissipation assembly provided in this application may be used in a vehicle. For example, the heat dissipation assembly may be used in a vehicle-mounted computing apparatus in a vehicle. The vehicle-mounted computing apparatus may be applied to automated driving (automated driving) of an intelligent vehicle. The intelligent vehicle includes an electric vehicle that supports unmanned driving (unmanned driving), driver assistance (driver assistance/ADAS), intelligent driving (intelligent driving), connected driving (connected driving), intelligent network driving (intelligent network driving), and car sharing (car sharing), or a gasoline-driven vehicle. The vehicle-mounted computing apparatus is configured to perform driving state control and state monitoring on the intelligent vehicle, and includes but is not limited to a vehicle-mounted mobile data center (mobile data center, MDC), a hardware monitor interface (hardware monitor interface, HMI) that implements a man-machine interaction controller function, an in-vehicle infotainment (in-vehicle infotainment, IVI) controller, a body control module (body control module, BCM), or a vehicle control unit (vehicle control unit, VCU). The vehicle-mounted computing apparatus may be specifically a chip with computing and processing capabilities, or may be a set that is of a plurality of devices such as a processor and a memory and that is integrated in a printed circuit board (printed circuit board, PCB). The processor includes but is not limited to a central processing unit (central processing unit, CPU), a general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or transistor logic device, a discrete hardware assembly, a graphics processing unit (graphics processing unit, GPU), or an artificial intelligence (artificial intelligence, AI) chip. The general-purpose processor may be a microprocessor, or may be any conventional processor or the like. It can be learned from the foregoing description that a chip with large computation amount is disposed in the vehicle-mounted computing apparatus. Therefore, the chip has a high requirement for heat dissipation when being used. Therefore, this application provides a heat dissipation assembly to improve a heat dissipation effect of the chip in the vehicle-mounted computing apparatus.

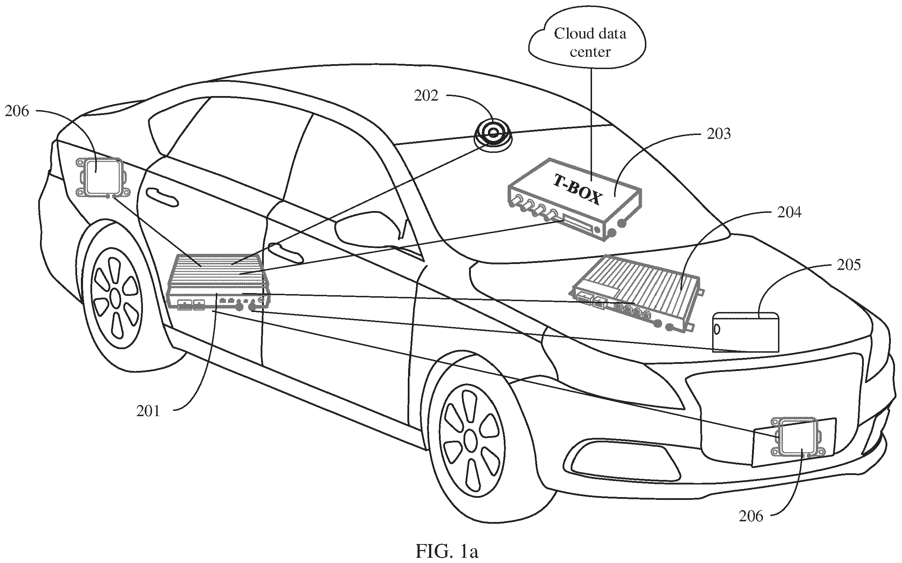

For example, as shown in FIG. 1a, a vehicle-mounted computing apparatus 201 may be mounted at a proper position, for example, in a center console or near a vehicle liquid cooling pump, to detect, by using various sensors (for example, a millimeter-wave radar 206, a lidar 205, and a camera 202) mounted on a vehicle body, an environment in which a vehicle is located, then the environment is fed back to a chip and the like built in the vehicle-mounted computing apparatus 201 for real-time reasoning operation, and finally, the vehicle-mounted computing apparatus 201 delivers an operation command to a vehicle control unit (vehicle control unit, VCiJ) 204, so that the VCU 204 controls and maneuvers (brakes, decelerates, and the like) the vehicle, to implement automated driving functions of various levels. The vehicle-mounted computing apparatus 201 may further upload data to a cloud data center at a back end by using a T-BOX (telematics BOX) 203. Optionally, the vehicle-mounted computing apparatus 201 may perform transmission with the camera 202 through a multimedia serial link (multimedia serial link, MSL), perform transmission with the lidar 205 through a vehicle-mounted Ethernet link, perform transmission with the VCU 204 through a controller area network (controller area network, CAN) bus, perform transmission with the millimeter-wave radar 206 through the CAN bus, and perform transmission with the T-BOX 203 through the vehicle-mounted Ethernet link.

The vehicle-mounted computing apparatus 201 in this application may include a heat dissipation assembly, configured to provide heat dissipation for a heat emitting device in the vehicle-mounted computing apparatus 201.

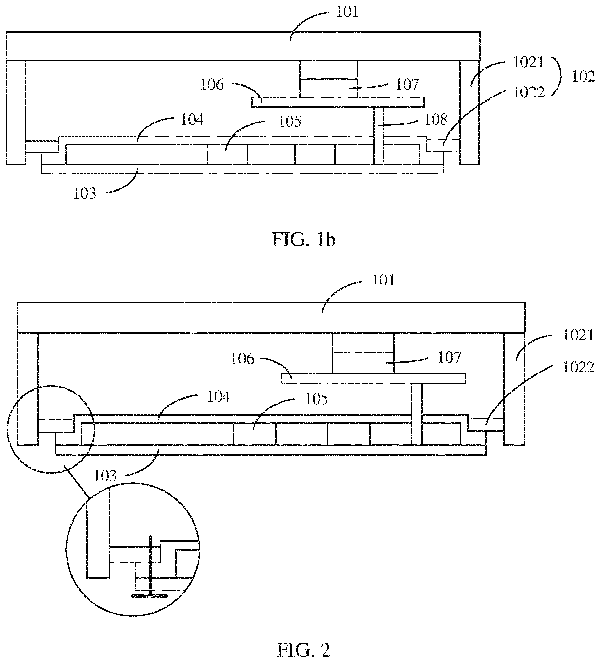

FIG. 1b shows a schematic structure of a heat dissipation assembly according to an embodiment of this application. As shown in FIG. 1b, the heat dissipation assembly provided in this embodiment of this application includes a liquid cold plate 101, a temperature equalization plate 104, and a thermally conductive assembly 102.

In this embodiment of this application, one side of the temperature equalization plate 104 is attached to a heat emitting device 105 on a main board 103.

The temperature equalization plate 104 may be a thin copper plate with good thermal conductivity, a thin aluminum plate welded with a heat pipe, a thin flat heat pipe, a graphene sheet, or the like. This is not limited in this application.

The temperature equalization plate 104 may include two sides, and one of the two sides is attached to the heat emitting device 105 on the main board 103.

In this embodiment of this application, the main board 103 may be a PCB board, one or more heat emitting devices 105 may be disposed on the main board 103, and the heat emitting device 105 may be a device, for example, an SOC, a local area network switch LAN SW, or a microcontroller unit (microcontroller unit, MCU).

In this embodiment of this application, as shown in FIG. 1b, one side of the temperature equalization plate 104 is attached to the heat emitting device 105 on the main board 103. This is equivalent to that one side of the heat emitting device 105 is fastened on the main board 103, and the other side of the heat emitting device 105 is attached to the temperature equalization plate 104. It should be understood that one side of the temperature equalization plate 104 may directly contact and may be attached to the heat emitting device 105 on the main board 103, or may be indirectly attached to the heat emitting device 105 by using some thermally conductive materials, provided that heat generated by the heat emitting device 105 can be effectively transferred to the temperature equalization plate 104. An attachment manner between the heat emitting device 105 and the temperature equalization plate 104 is not limited in this embodiment.

As shown in FIG. 1b, in this embodiment of this application, a central area of the temperature equalization plate 104 is attached to the heat emitting device 105 on the main board 103, and an edge area of the temperature equalization plate 104 extends to the main board 103 and is fastened on the main board 103. This is equivalent to that the temperature equalization plate 104 is of a "cover-shaped" structure. The central area of the temperature equalization plate 104 protrudes in a direction away from the main board to form a hollowed area. An inner wall of the hollowed area may be attached to the heat emitting device 105, and the edge area of the temperature equalization plate 104 is fastened to the main board 103, so that heat on the main board 103 can be transferred to the temperature equalization plate 104. It should be understood that the "central area" and the "edge area" are relative position expressions, and are not absolute position limitations. In other words, the central area of the temperature equalization plate 104 is closer to a center of the temperature equalization plate 104 relative to the edge area. In another implementation, a non-edge area of the temperature equalization plate 104 may alternatively be fastened to the main board 103, provided that it can be ensured that the temperature equalization plate 104 is fastened to the main board 103, and an area for the heat emitting device 105 can be reserved between the temperature equalization plate 104 and the main board 103. A fastening manner between the temperature equalization plate 104 and the main board 103 is not limited in this application.

In this embodiment of this application, the liquid cold plate 101 is disposed on a side that is of the temperature equalization plate 104 and that is away from the main board 103.

The liquid cold plate 101 may be of a structure that has thermal conduction and heat dissipation functions. In an optional implementation, the liquid cold plate 101 is a metal plate. For example, the liquid cold plate 101 is an aluminum alloy material or a steel plate. In another implementation, the liquid cold plate 101 may alternatively be another thermally conductive material, for example, a ceramic plate or plastic having a thermal conduction capability. In another implementation, the liquid cold plate 101 may include a pipeline, and the pipeline may be filled with liquid, so that heat is removed through liquid flowing. The liquid may be water or another refrigerant (for example, freon R22).

In this embodiment of this application, the liquid cold plate 101 may be connected to the temperature equalization plate 104 by using the thermally conductive assembly 102, so that the heat generated by the heat emitting device 105 is transferred to the liquid cold plate 101 by using the temperature equalization plate 104 and the thermally conductive assembly 102.

In a possible implementation, one end of the thermally conductive assembly 102 is fastened to the liquid cold plate 101, and the other end of the thermally conductive assembly 102 extends to the temperature equalization plate 104 and is connected to the temperature equalization plate 104.

FIG. 2 shows a schematic structure of a heat dissipation assembly according to an embodiment of this application. As shown in FIG. 2, the thermally conductive assembly 102 may include a thermally conductive assembly body 1021 and a boss 1022, where one end of the thermally conductive assembly body 1021 is fastened to the liquid cold plate 101, the other end of the thermally conductive assembly 102 extends to the temperature equalization plate 104, and the boss 1022 disposed at the other end of the thermally conductive assembly 102 is connected to the temperature equalization plate 104. As shown in FIG. 2, both the temperature equalization plate 104 and the main board 103 may be fastened on the boss 1022 of the thermally conductive assembly 102 by using screws, so that the temperature equalization plate 104 tightly contacts the boss 1022. It should be understood that copper exposure processing may be performed on a part that is of the main board 103 and that contacts the temperature equalization plate 104, so that the heat on the main board 103 can be transferred to the boss 1022 on the liquid cold plate 101 by using the temperature equalization plate 104, heat transfer is implemented, and a temperature of the main board 103 is reduced.

In this embodiment of this application, the temperature equalization plate 104 can collect the heat of the heat emitting device 105 on the main board 103 and transfer the heat to the liquid cold plate 101, to dissipate the heat from the heat emitting device 105.

In a possible implementation, the PCB board 106 is fastened between the temperature equalization plate 104 and the liquid cold plate 101, a connector 108 is fastened on the PCB board 106, one end of the connector 108 is connected to the PCB board 106, the connector 108 passes through the temperature equalization plate 104, and the other end of the connector 108 extends to the main board 103 and is fastened on the main board 103. An SOC 107 is arranged on the PCB board 106. The SOC 107 may be an AI chip.

In this embodiment of this application, the PCB board 106 arranged with the AI chip may be fastened on the main board 103. In an existing implementation, the liquid cold plate 101 is disposed between the PCB board 106 arranged with the Al chip and the main board 103 to dissipate heat from the PCB board 106 arranged with the AI chip and the heat emitting device 105 on the main board 103. However, in an aspect, the PCB board 106 arranged with the AI chip is connected to the main board 103 by using the connector 108, the connector 108 affects a structure of the liquid cold plate 101, and a distance between the PCB board 106 arranged with the AI chip and the main board 103 is excessively small. Consequently, a thickness of the liquid cold plate 101 is limited, and heat dissipation efficiency is low. In this embodiment of this application, the liquid cold plate 101 is disposed on a side that is of the PCB board 106 and that is away from the main board 103, the connector 108 passes through only the temperature equalization plate 104 between the main board 103 and the PCB board 106 without passing through the liquid cold plate 101. Because the temperature equalization plate 104 conducts heat by using metal and does not have a runner inside, a problem that a heat dissipation capability is significantly degraded because a runner is interrupted does not exists.

As shown in FIG. 1b, in a possible implementation, the SOC 107 is arranged on a side that is of the PCB board 106 and that faces the liquid cold plate 101, and the SOC 107 is attached to the liquid cold plate 101, to ensure heat dissipation of the SOC 107 on the PCB board 106. In this case, heat generated by the SOC 107 on the PCB board 106 or another heat emitting device 105 can be directly transferred to the liquid cold plate 101.

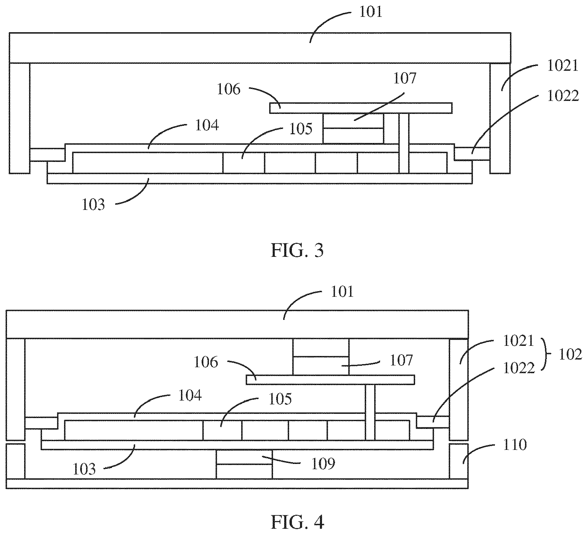

FIG. 3 shows a schematic structure of a heat dissipation assembly according to an embodiment of this application. As shown in FIG. 3, in a possible implementation, the SOC 107 is arranged on a side that is of the PCB board 106 and that faces the temperature equalization plate 104, and the SOC 107 is attached to the temperature equalization plate 104. In this case, heat generated by the SOC 107 on the PCB board 106 or another heat emitting device 105 can be transferred to the temperature equalization plate 104, and be further transferred to the liquid cold plate 101 by using the temperature equalization plate 104 and the thermally conductive assembly 102.

It should be understood that a heat emitting device 109 (as shown in FIG. 4) may be further arranged on a side that is of the main board and that is away from the temperature equalization plate, a bottom housing may be further disposed on the side that is of the main board and that is away from the temperature equalization plate, and the heat emitting device 109 may be in a thermally conductive contact with the bottom housing 110. In this embodiment, the liquid cold plate 101, the thermally conductive assembly 102, and the bottom housing may be fastened to be used as a housing of a vehicle-mounted computing apparatus.

The heat dissipation assembly in this application may be used in the vehicle-mounted computing apparatus, and the heat dissipation assembly can provide a heat dissipation function for a PCB board in the vehicle-mounted computing apparatus and a heat emitting device on the PCB board.

An embodiment of this application provides a heat dissipation assembly, including a liquid cold plate 101, a temperature equalization plate 104, and a thermally conductive assembly 102, where one side of the temperature equalization plate 104 is attached to a heat emitting device 105 on a main board 103; the liquid cold plate 101 is disposed on a side that is of the temperature equalization plate 104 and that is away from the main board 103; and the liquid cold plate 101 is connected to the temperature equalization plate 104 by using the thermally conductive assembly 102, so that heat generated by the heat emitting device 105 is transferred to the liquid cold plate 101 by using the temperature equalization plate 104 and the thermally conductive assembly 102. In the foregoing manner, the temperature equalization plate 104 is added to the main board 103, and the liquid cold plate 101 is disposed on the side that is of the temperature equalization plate 104 and that is away from the main board 103. The temperature equalization plate 104 transfers the heat of the heat emitting device 105 on the main board 103 to the liquid cold plate 101. A PCB board 106 may be disposed between the temperature equalization plate 104 and the liquid cold plate 101, so that a runner in the liquid cold plate 101 is not interrupted by a connector 108 between the PCB board 106 and the main board 103, thereby improving heat dissipation performance of the liquid cold plate 101.

In addition, it should be noted that the described apparatus embodiments are merely examples. The units described as separate parts may or may not be physically separate, and parts displayed as units may or may not be physical units, may be located in one position, or may be distributed on a plurality of network units. Some or all the modules may be selected based on an actual requirement to achieve the objectives of the solutions of embodiments. In addition, in the accompanying drawings of the apparatus embodiments provided in this application, connection relationships between modules indicate that the modules have communication connections with each other, and may be specifically implemented as one or more communication buses or signal cables.

Based on the descriptions of the foregoing implementations, a person skilled in the art may clearly understand that this application may be implemented by software in addition to necessary universal hardware, or by dedicated hardware, including a dedicated integrated circuit, a dedicated CPU, a dedicated memory, a dedicated component, and the like. Generally, any function that can be performed by a computer program can be easily implemented by using corresponding hardware. Moreover, a specific hardware structure used to achieve a same function may be in various forms, for example, in a form of an analog circuit, a digital circuit, or a dedicated circuit. However, as for this application, software program implementation is a better implementation in most cases. Based on such an understanding, the technical solutions in this application may be essentially or a part that contributes to the conventional technology may be reflected in a form of a software product. The computer software product is stored in a readable storage medium, for example, a floppy disk, a USB flash drive, a removable hard disk, a ROM, a RAM, a disk drive, or an optical disk of a computer, and includes some instructions used to enable a computer device (which may be a personal computer, a training device, a network device, or the like) to perform the method in embodiments of this application.

All or some of the foregoing embodiments may be implemented by using software, hardware, firmware, or any combination thereof. When software is used to implement the embodiments, all or a part of the embodiments may be implemented in a form of a computer program product.

The computer program product includes one or more computer instructions. When the computer instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

## Claims

1. A heat dissipation assembly, comprising a liquid cold plate (101), a thermally conductive plate (104), and a thermally conductive assembly (102), wherein
one side of the temperature equalization plate (104) is attached to a heat emitting device (105) on a main board (103);
the liquid cold plate (101) is disposed on a side that is of the temperature equalization plate (104) and that is away from the main board (103);
a PCB board (106) is fastened between the temperature equalization plate (104) and the liquid cold plate (101), a connector (108) is fastened on the PCB board (106), one end of the connector (108) is connected to the PCB board (106), the connector (108) passes through the temperature equalization plate (104), and the other end of the connector (108) extends to the main board (103) and is fastened on the main board (103); and
the liquid cold plate (101) is connected to the temperature equalization plate (104) by using the thermally conductive assembly (102).

2. The heat dissipation assembly according to claim 1, wherein one end of the thermally conductive assembly (102) is fastened to the liquid cold plate (101), and the other end of the thermally conductive assembly (102) extends to the temperature equalization plate (104) and is connected to the temperature equalization plate (104).

3. The heat dissipation assembly according to claim 1 or 2, wherein a central area of the temperature equalization plate (104) is attached to the heat emitting device (105) on the main board (103), and an edge area of the temperature equalization plate (104) extends to the main board (103) and is fastened on the main board (103).

4. The heat dissipation assembly according to any one of claims 1 to 3, wherein a system on chip, SOC is arranged on the PCB board (106).

5. The heat dissipation assembly according to claim 4, wherein the SOC is arranged on a side that is of the PCB board (106) and that faces the liquid cold plate (101), and the SOC is attached to the liquid cold plate (101).

6. The heat dissipation assembly according to claim 4, wherein the SOC is arranged on a side that is of the PCB board (106) and that faces the temperature equalization plate (104), and the SOC is attached to the temperature equalization plate (104).

7. A vehicle, comprising a vehicle body and the heat dissipation assembly according to any one of claims 1 to 6 that is disposed in the vehicle body.
